# EUROPÄISCHE PATENTANMELDUNG

(11) **EP 4 080 559 A1**
(43) Veröffentlichungstag der Anmeldung: **26.10.2022**
(21) Anmeldenummer: 21169684.4
(22) Anmeldetag: 21.04.2021
(51) Int. Cl.: H01L 23/367, H01L 23/373, H01L 23/427

(54) **HALBLEITERMODUL MIT EINEM SUBSTRAT UND ZUMINDEST EINEM AUF DEM SUBSTRAT KONTAKTIERTEN HALBLEITERBAUELEMENT**

(71) Anmelder: Siemens Aktiengesellschaft, 80333 München (DE)
(72) Erfinder: Müller, Volker, 90408 Nürnberg (DE); Neugebauer, Stephan, 91058 Erlangen (DE); Schwarz, Florian, 90766 Fürth (DE)

(57) **Zusammenfassung**

Die Erfindung betrifft ein Halbleitermodul (2) mit einem Substrat (4) und zumindest einem auf dem Substrat (4) kontaktierten Halbleiterbauelement (6), wobei das Substrat (4), insbesondere stoffschlüssig, mit einer Wärmesenke (28) verbunden ist. Um, im Vergleich zum Stand der Technik, eine effektivere Entwärmung zu ermöglichen, wird ein flächiges Kühlelement (18) vorgeschlagen, welches eine hermetisch verschlossene Kanalstruktur (22) aufweist, in welcher ein Wärmetransportmedium (24) angeordnet ist, wobei durch die hermetisch verschlossene Kanalstruktur (22) und das Wärmetransportmedium (24) eine pulsierende Heatpipe (26) ausgebildet ist, wobei über das flächige Kühlelement (18) eine thermische Verbindung zwischen einer dem Substrat (4) abgewandten Seite des zumindest einen Halbleiterbauelements (6) und der Wärmesenke (28) herstellt ist.

## Beschreibung

Die Erfindung betrifft ein Halbleitermodul mit einem Substrat und zumindest einem auf dem Substrat kontaktierten Halbleiterbauelement, wobei das Substrat, insbesondere stoffschlüssig, mit einer Wärmesenke verbunden ist.

Ferner betrifft die Erfindung einen Stromrichter mit mindestens einem derartigen Halbleitermodul.

Darüber hinaus betrifft die Erfindung ein Verfahren zur Herstellung eines Halbleitermoduls mit einem Substrat und zumindest einem auf dem Substrat kontaktierten Halbleiterbauelement, wobei das Substrat, insbesondere stoffschlüssig, mit einer Wärmesenke verbunden wird.

Derartige Halbleitermodule kommen in der Regel in einem Stromrichter zum Einsatz. Unter einem Stromrichter ist beispielsweise ein Gleichrichter, ein Wechselrichter, ein Umrichter oder ein Gleichspannungswandler zu verstehen.

Mit der fortschreitenden Miniaturisierung in der Aufbau- und Verbindungstechnik, beispielsweise durch eine planare Aufbau- und Verbindungstechnik, nimmt die Leistungsdichte in Halbleitermodulen zu. Um Elektronikausfälle durch thermische Überlastungen zu vermeiden, werden daher immer effektivere, aber auch kostengünstigere Konzepte zum Entwärmen von Halbleiterbauelementen benötigt.

Die Offenlegungsschrift EP 3 625 823 A1 beschreibt ein Leistungsmodul mit mindestens einem Leistungshalbleiter, insbesondere einem Leistungstransistor, welcher eine erste Kontaktfläche und eine der ersten Kontaktfläche gegenüberliegende zweite Kontaktfläche aufweist, und einem Substrat, welches zumindest zwei übereinander angeordnete miteinander verbundene Lagen umfasst. Um eine, im Vergleich zum Stand der Technik, höhere Beständigkeit gegenüber Feuchtigkeit zu erreichen und eine niederinduktive planare Anbindung des mindestens einen Leistungshalbleiters zu ermöglichen, wird vorgeschlagen, dass die erste Lage ein erstes dielektrisches Material mit zumindest einer ersten Metallisierung umfasst, wobei die erste Metallisierung auf einer der zweiten Lage zugewandten Seite angeordnet ist, wobei die zweite Lage ein zweites dielektrisches Material mit zumindest einer zweiten Metallisierung umfasst, wobei die zweite Metallisierung auf einer der ersten Metallisierung abgewandten Seite angeordnet ist, wobei der Leistungshalbleiter über die erste Kontaktfläche mit der ersten Metallisierung verbunden ist, wobei der Leistungshalbleiter in einer ersten Aussparung der zweiten Lage angeordnet ist, wobei eine metallische erste Kapselung derartig angeordnet ist, dass der Leistungshalbleiter fluiddicht gekapselt ist und die zweite Kontaktfläche des Leistungshalbleiters über die erste Kapselung elektrisch leitend mit der zweiten Metallisierung verbunden ist.

Die Offenlegungsschrift EP 3 547 360 A1 beschreibt eine Halbleiterbaugruppe, umfassend ein Trägerelement mit einer ersten Trägerelement-Leiterbahn, einen Halbleiter, ein elektrisch isolierendes Element, aufweisend eine erste Isolationselement-Leiterbahn, und ein erstes Abstandselement, wobei der Halbleiter an einer ersten Halbleiterseite mittels eines ersten Verbindungsmaterials mit der ersten Trägerelement-Leiterbahn elektrisch und mechanisch verbunden ist, wobei der Halbleiter an einer zweiten Halbleiterseite, welche von der ersten Halbleiterseite des Halbleiters abgewandt ist, mittels eines zweiten Verbindungsmaterials mit der ersten Isolationselement-Leiterbahn, welche an einer ersten Isolationselementseite des elektrisch isolierenden Elements angeordnet ist, elektrisch und mechanisch verbunden ist und wobei das erste Abstandselement zum Halten eines Abstands zwischen dem Trägerelement und einem der zweiten Halbleiterseite des Halbleiters zugewandten Baugruppenelement angeordnet und jeweils mit dem Trägerelement und dem Baugruppenelement mechanisch verbunden ist.

Die Offenlegungsschrift EP 3 751 605 A1 beschreibt einen elektronischen Schaltkreis mit einem ersten und einem zweiten Schaltungsträger sowie einem ersten und einem zweiten Halbleiterbauelement. Das erste Halbleiterbauelement liegt mit einer Oberseite an einer Unterseite des ersten Schaltungsträgers an sowie mit einer Unterseite an einer Oberseite des zweiten Schaltungsträgers. Der erste Schaltungsträger weist eine erste Durchkontaktierung auf, welche das erste Halbleiterbauelement mit einer ersten Leiterbahn verbindet. Der erste Schaltungsträger weist eine zweite Durchkontaktierung auf, welche ein zwischen den Schaltungsträgern angeordnetes Verbindungselement mit einer weiteren Leiterbahn elektrisch verbindet. Über das erste Verbindungselement wird eine stoffschlüssige Verbindung zwischen den Schaltungsträgern hergestellt. Das zweite Halbleiterbauelement liegt an der Unterseite des ersten Schaltungsträgers an und ist elektrisch mit der ersten oder zweiten Leiterbahn verbunden.

Die Offenlegungsschrift WO 2020/207669 A1 beschreibt eine Wärmeübertragungsvorrichtung welche mindestens eine wärmeableitende Struktur und mindestens eine Wärmekammer umfasst, wobei die wärmeableitende Struktur und die Wärmekammer zu einem geschlossenen thermischen Kreislauf gekoppelt sind, wobei die wärmeableitende Struktur einen Ausgangskanal umfasst, der von der Wärmekammer abgeht und der an einem von der Wärmekammer abgewandten Ende in mindestens einen Rücklaufkanal mündet, wobei der Rücklaufkanal kleiner dimensioniert ist als der Ausgangskanal und in die Wärmekammer mündet und wobei die mindestens eine Wärmekammer eine Siede- oder Dampfkammer ist und die mindestens eine wärmeableitende Struktur eine Kanalstruktur mit Dampfbereichen und Flüssigbereichen ist, wobei die Wärmekammer und die wärmeableitende Struktur zusammen einen pulsierenden oder oszillierenden Heizstrukturmechanismus bilden.

Vor diesem Hintergrund liegt der Erfindung die Aufgabe zugrunde, eine Halbleitermodulanordnung anzugeben, welche eine, im Vergleich zum Stand der Technik, effektivere Entwärmung ermöglicht.

Diese Aufgabe wird erfindungsgemäß dadurch gelöst, dass ein Halbleitermodul der eingangs genannten Art ein flächiges Kühlelement umfasst, welches eine hermetisch verschlossene Kanalstruktur aufweist, in welcher ein Wärmetransportmedium angeordnet ist, wobei durch die hermetisch verschlossene Kanalstruktur und das Wärmetransportmedium eine pulsierende Heatpipe ausgebildet ist, wobei über das flächige Kühlelement eine thermische Verbindung zwischen einer dem Substrat abgewandten Seite des zumindest einen Halbleiterbauelements und der Wärmesenke herstellt ist.

Ferner wird die Aufgabe erfindungsgemäß gelöst durch einen Stromrichter mit mindestens einer derartigen Halbleitermodulanordnung.

Darüber hinaus wird die Aufgabe erfindungsgemäß dadurch gelöst, dass bei einem Verfahren zur Herstellung eines Halbleitermodul der eingangs genannten Art über ein flächiges Kühlelement eine thermische Verbindung zwischen einer dem Substrat abgewandten Seite des zumindest einen Halbleiterbauelements und der Wärmesenke herstellt wird, wobei das flächige Kühlelement eine hermetisch verschlossene Kanalstruktur aufweist, in welcher ein Wärmetransportmedium angeordnet wird, wobei durch die hermetisch verschlossene Kanalstruktur und das Wärmetransportmedium eine pulsierende Heatpipe ausgebildet wird.

Die in Bezug auf das Halbleitermodul nachstehend angeführten Vorteile und bevorzugten Ausgestaltungen lassen sich sinngemäß auf den Stromrichter und das Herstellungsverfahren übertragen.

Der Erfindung liegt die Überlegung zugrunde, in einem Halbleitermodul einen zusätzlichen Wärmepfad mit einer pulsierenden Heatpipe bereitzustellen, sodass die Entwärmung durch Wärmespreizung verbessert wird. Eine pulsierende Heatpipe (engl. pulsating heat pipe, PHP), die auch als oszillierende Heatpipe (engl. oscillating heat pipe, OHP) bezeichnet wird, ist eine Vorrichtung zur Wärmeübertragung mit einer geschlossenen Kanalstruktur, in der ein Wärmetransportmedium, insbesondere ein Wärmetransportfluid, angeordnet ist, dass entlang der Kanalstruktur durch die Oberflächenspannung des Wärmetransportmediums abwechselnd Dampfsegmente und Flüssigsegmente bildet. Diese Dampf- und Flüssigsegmente werden durch einen Temperaturgradienten zum Pulsieren beziehungsweise Oszillieren angeregt. An einer Wärmequelle dehnen sich die Dampfsegmente aufgrund der höheren Temperatur aus; zudem siedet flüssiges Wärmetransportmedium dort und nimmt dabei latente Wärme auf. An einer Wärmesenke schrumpfen die Dampfsegmente durch Kondensation gasförmigen Wärmetransportmediums und geben dabei latente Wärme ab. Die lokalen Temperatur- und Druckunterschiede treiben das ständige Pulsieren beziehungsweise Oszillieren der Dampf- und Flüssigsegmente an.

Das Halbleitermodul weist ein Substrat und zumindest ein auf dem Substrat kontaktiertes Halbleiterbauelement auf, wobei das Substrat, insbesondere stoffschlüssig, mit einer Wärmesenke verbunden ist. Das Halbleiterbauelement kann als Transistor, insbesondere als Insulated-Gate-Bipolar-Transistor, ausgeführt sein. Ferner kann der Transistor eine antiparallele Diode aufweisen. Alternativ kann das Halbleiterbauelement als digitaler Logikbaustein, insbesondere als Field Programmable Gate Array (FPGA), oder als ein anderer Halbleiter ausgeführt sein. Die Wärmesenke umfasst beispielsweise eine Bodenplatte und/oder einen Kühlkörper. Der zusätzliche Wärmepfad, welcher beispielsweise an einer Oberseite des Halbleitermoduls verläuft, wird erzeugt, indem durch ein flächiges Kühlelement eine thermische Verbindung zwischen einer dem Substrat abgewandten Seite des zumindest einen Halbleiterbauelements und der Wärmesenke hergestellt wird. Ein derartiges Kühlelement gilt insbesondere als flächig, wenn seine Dicke, beispielsweise bei einer im Wesentlichen rechteckigen Grundfläche, maximal 10 % eines Mittelwerts aus einer kürzesten und einer längsten Seitenlänge beträgt, wobei die Länge der kürzesten Seite mindestens 10 % der Länge der längsten Seite beträgt. Insbesondere beträgt eine maximale Dicke des flächigen Kühlelements 4 mm, insbesondere 2 mm. Beispielsweise ist das flächige Kühlelement mit einer Metallisierung des Substrats und/oder mit der Wärmesenke sowie mit einer Kontaktfläche des Halbleiterbauelements, welche auf einer dem Substrat abgewandten Seite angeordnet ist, kontaktiert. Das flächige Kühlelement weist eine hermetisch verschlossene Kanalstruktur auf, in welcher ein Wärmetransportmedium angeordnet ist, wobei durch die hermetisch verschlossene Kanalstruktur und das Wärmetransportmedium eine pulsierende Heatpipe ausgebildet ist. Eine derartige Kanalstruktur ist beispielsweise mittels einer Blechstruktur realisierbar. Das Wärmetransportmedium ist insbesondere als Wärmetransportfluid ausgeführt, welches beispielsweise Wasser, Aceton oder Methanol enthält. Die Kanalstruktur umfasst beispielsweise Kanäle mit einem kreisförmigen Querschnitt, wobei der kreisförmige Querschnitt insbesondere einen maximalen Durchmesser von 3 mm insbesondere 1 mm aufweist. Beispielsweise sind die Kanäle der hermetisch verschlossenen Kanalstruktur mäanderförmig und/oder schleifenförmig angeordnet, sodass durch die pulsierende Heatpipe eine Wärmespreizung stattfindet. Eine Wärmeflussrichtung ist durch den Verlauf der Kanäle flexibel einstellbar. Durch den zusätzlichen Wärmepfad und die Wärmespreizung wird eine effektive Entwärmung ermöglicht. Gleichzeitig findet eine Homogenisierung der Temperaturen im Halbleitermodul statt, die sich positiv auf eine Lebensdauer oder eine Robustheit gegenüber einseitigen Lastfällen auswirkt. Insbesondere bei einem Einsatz von innerhalb des Moduls parallel geschalteten Halbleitern ist eine derartige Homogenisierung der Temperaturen vorteilhaft. Eine Hauptwärmepfad, welcher über das Substrat zur Wärmesenke verläuft, wird durch eine zweiseitige Entwärmung entlastet.

Eine weitere Ausführungsform sieht vor, dass das flächige Kühlelement zumindest abschnittsweise flexibel ausgebildet ist. Durch die zumindest abschnittsweise flexible Ausführung wird eine Umformung durch Deformation ermöglicht. Ferner wird eine zuverlässige Entwärmung durch die zumindest abschnittsweise flexible Ausführung auch bei, insbesondere thermischen, Wechselbelastungen gewährleitet.

Eine weitere Ausführungsform sieht vor, dass eine Form des flächigen Kühlelements an ein Höhenprofil des jeweiligen Schaltungslayouts angepasst ist. Durch eine Anpassung an das Höhenprofil des Schaltungslayouts werden Höhen- und ggf. Winkelversätze, z.B. aufgrund der Halbleiterbauelemente und weiterer Beschaltung, ausgeglichen. Durch eine geometrische Anpassbarkeit an das jeweilige Schaltungslayout kann auf Zwischenelemente verzichtet werden, was thermische Kontaktwiderstände reduziert. Ferner wird eine Dicke und damit ein erforderlicher Bauraum reduziert.

Eine weitere Ausführungsform sieht vor, dass das flächige Kühlelement stoffschlüssig oder kraftschlüssig mit dem Halbleiterbauelement verbunden ist. Eine stoffschlüssige Verbindung kann beispielsweise mittels Löten, Sintern oder Kleben hergestellt werden, was zu einer stabilen Verbindung mit geringen thermischen Kontaktwiderständen führt. Eine kraftschlüssige Verbindung kann beispielsweise durch zumindest ein elastisches Anpresselement hergestellt werden. Eine derartige Verbindung ist leicht lösbar und einfach zu realisieren.

Eine weitere Ausführungsform sieht vor, dass das flächige Kühlelement zumindest teilweise mittels eines additiven Verfahrens hergestellt ist. Ein derartiges additives Verfahren ist beispielsweise Selektive Lasersintern (SLS) oder ein Extrusionsverfahren, wodurch auch komplexe Geometrien, welche insbesondere einen Kunststoff enthalten, vergleichsweise einfach und kostengünstig herstellbar sind. Durch eine Kombination des additiven Fertigungsverfahrens mit einem weiteren Fertigungsverfahren sind insbesondere Verbundwerkstoffe wie Faserverbundwerkstoffe effizient herstellbar.

Eine weitere Ausführungsform sieht vor, dass das flächige Kühlelement mittels eines Gussverfahrens hergestellt ist. Ein derartiges Gussverfahren ist beispielsweise Gasinjektion oder Schleuderguss. Insbesondere bei großen Stückzahlen ist ein derartiges Gussverfahren kostengünstig und zuverlässig reproduzierbar.

Eine weitere Ausführungsform sieht vor, dass das flächige Kühlelement aus profilierten und gefügten Blechen hergestellt ist. Derartige Bleche enthalten beispielsweise Kupfer und weisen eine zumindest teilweise wellenförmige Profilierung auf. Eine Profilierung wird beispielsweise durch Biege, Prägen oder Fräsen hergestellt. Zumindest zwei Bleche werden beispielsweise mittels einer unlösbaren Verbindung, insbesondere einer Schweißverbindung und/oder Lötverbindung, stoffschlüssig verbunden, sodass zwischen den Blechen Kanäle ausgebildet werden. Ein derartiges flächiges Kühlelement ist einfach und kostengünstig herstellbar.

Eine weitere Ausführungsform sieht vor, dass die hermetisch verschlossene Kanalstruktur einen endgültig geformten Kanal aufweist, welcher durch Deformation des flächigen Kühlelements aus einem vorgeformten Kanal hergestellt ist, wobei sich eine Geometrie des endgültig geformten Kanals von einer Geometrie des vorgeformten Kanals unterscheidet. Eine Geometrie eines Kanals ist insbesondere durch einen Querschnitt definiert. Beispielsweise ist die Geometrie des endgültig geformten Kanals eine Zielgeometrie, welche einen kreisförmigen Kanalquerschnitt umfasst, wobei der vorgeformte Kanal z.B. einen ovalen Querschnitt aufweist. Durch einen derartigen vorgeformten Kanal ist gewährleitet, dass die Kanalstruktur auch bei einer Deformation des flächigen Kühlelements ausreichend geöffnete Kanäle umfasst.

Eine weitere Ausführungsform sieht vor, dass das flächige Kühlelement zumindest teilweise aus einem thermisch leitfähigen und elektrisch isolierenden Werkstoff hergestellt ist. Ein derartiger Werkstoff ist beispielsweise ein keramischer Werkstoff oder ein, insbesondere mit einem keramischen Werkstoff gefüllter, Kunststoff. Durch einen derartigen Werkstoff ist beispielsweise eine dedizierte Isolationslage 20 nicht erforderlich, sodass thermische Kontaktwiderstände reduziert werden.

Eine weitere Ausführungsform sieht vor, dass das flächige Kühlelement aus einem metallischen Werkstoff hergestellt ist, wobei zwischen dem Halbleiterbauelement und dem flächigen Kühlelement eine Isolationslage angeordnet ist. Der metallische Werkstoff enthält beispielsweise Kupfer oder Aluminium. Die Isolationslage ist beispielsweise als eine, insbesondere bereits vorhandene, Folie, welche insbesondere aus einem isolierenden Werkstoff hergestellt ist, ausgeführt, sodass eine im Halbleiterbauelement entstehende Wärme über das aus dem metallischen Werkstoff hergestellte flächige Kühlelement effizient ableitbar ist.

Eine weitere Ausführungsform sieht vor, dass das flächige Kühlelement zumindest teilweise aus einem metallischen Werkstoff hergestellt ist, wobei das flächige Kühlelement unmittelbar mit einer Kontaktfläche des Halbleiterbauelements kontaktiert ist. Unter einer unmittelbaren Kontaktierung ist eine direkte Kontaktierung zu verstehen, die beispielsweise Verbindungsmittel zur Herstellung einer stoffschlüssigen Verbindung, wie Kleber, Lötzinn oder Sinterpaste, einschließt, ein zusätzliches Verbindungselement, wie einen zusätzlichen Leiter, ein Metallblech oder einen Abstandshalter, insbesondere zwischen dem flächige Kühlelement und der Kontaktfläche des Halbleiterbauelements, jedoch ausschließt. Beispielsweise ist das aus einem metallischen Werkstoff hergestellte flächige Kühlelement stoffschlüssig mit der Kontaktfläche des Halbleiterbauelements sowie mit der ersten Metallisierung des Substrats verbunden. Die stoffschlüssige Verbindung wird beispielsweise durch Löten hergestellt. Durch eine derartige unmittelbare Verbindung werden thermische Kontaktwiderstände reduziert.

Eine weitere Ausführungsform sieht vor, dass das flächige Kühlelement zum Leiten eines Laststromes des kontaktierten Halbleiterbauelements konfiguriert ist. Das flächige Kühlelement fungiert also als Leiter. Somit werden Bauraum und Kosten eingespart.

Im Folgenden wird die Erfindung anhand der in den Figuren dargestellten Ausführungsbeispiele näher beschrieben und erläutert.

Es zeigen:
- FIG 1: eine schematische Darstellung einer ersten Ausgestaltung eines Halbleitermoduls im Querschnitt,
- FIG 2: eine schematische Darstellung einer zweiten Ausgestaltung eines Halbleitermoduls im Querschnitt,
- FIG 3: eine schematische Darstellung einer Deformation eines flächiges Kühlelements,
- FIG 4: eine schematische Darstellung einer dritten Ausgestaltung eines Halbleitermoduls im Querschnitt,
- FIG 5: eine schematische Darstellung einer vierten Ausgestaltung eines Halbleitermoduls im Querschnitt,
- FIG 6: eine schematische Darstellung einer fünften Ausgestaltung eines Halbleitermoduls im Querschnitt,
- FIG 7: eine schematische Darstellung einer sechsten Ausgestaltung eines Halbleitermoduls im Querschnitt und
- FIG 8: eine schematische Darstellung eines Stromrichters mit einem Halbleitermodul.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

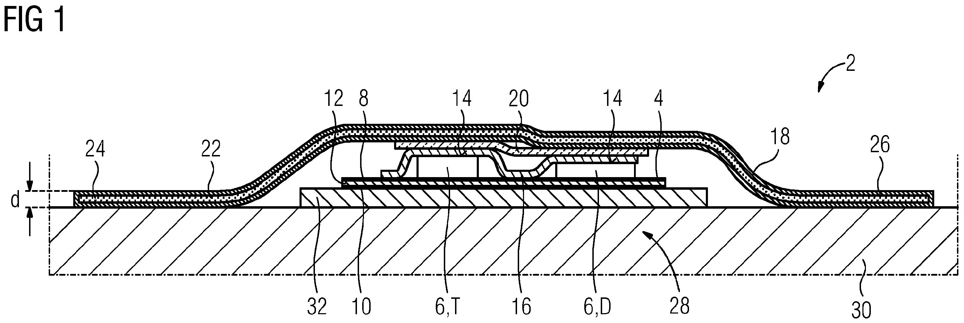

FIG 1 zeigt eine schematische Darstellung einer ersten Ausgestaltung eines Halbleitermoduls 2, das ein Substrat 4 und auf dem Substrat 4 kontaktierte Halbleiterbauelemente 6 umfasst. Das Substrat 4 weist eine, insbesondere strukturierte, erste Metallisierung 8 auf, auf welcher die Halbleiterbauelemente 6 kontaktiert sind. Die, insbesondere strukturierte, erste Metallisierung 8 ist beispielsweise als Kupferkaschierung ausgeführt. Insbesondere sind die Halbleiterbauelemente 6 stoffschlüssig mit der ersten Metallisierung 8 des Substrats 4 verbunden. Die stoffschlüssige Verbindung wird beispielsweise durch Löten, Kleben oder Sintern hergestellt. Darüber hinaus weist das Substrat 4 eine auf einer den Halbleiterbauelementen 6 abgewandten Seite eine zweite Metallisierung 10 auf, welche beispielsweise Kupfer enthält und durch eine dielektrische Materiallage 12 von der ersten Metallisierung 8 elektrisch isoliert und thermisch leitfähig verbunden ist. Die dielektrische Materiallage 12 weist beispielsweise eine Stärke von 25 µm bis 400 µm, insbesondere 50 µm bis 300 µm, auf und enthält einen keramischen Werkstoff, beispielsweise Aluminiumnitrid oder Aluminiumoxid, oder einen organischen Werkstoff, beispielsweise einem Polyamid. Das Substrat 4 kann alternativ als IMS-Substrat, bei welchem insbesondere die zweite Metallisierung 10 entfällt, ausgeführt sein.

Die Halbleiterbauelemente 6 in FIG 1 sind beispielhaft als Transistor T, insbesondere als Insulated-Gate-Bipolar-Transistor (IGBT), mit einer antiparallelen Diode D ausgeführt. Aus Gründen der Übersichtlichkeit ist ein Steuerkontakt, insbesondere Gatekontakt, des IGBTs in FIG 1 nicht dargestellt. Alternativ ist zumindest ein Halbleiterbauelement 6 als digitaler Logikbaustein, insbesondere als Field Programmable Gate Array (FPGA), oder als ein anderer Halbleiter ausgeführt. Auf einer dem Substrat 4 abgewandten Seite weisen die Halbleiterbauelemente 6 eine Kontaktfläche 14 auf. Über eine planare Leiterverbindung 16 sind die Kontaktflächen 14 der Halbleiterbauelemente 6 mit der ersten Metallisierung 8 des Substrats 4 verbunden. Die planare Leiterverbindung 16 ist beispielsweise als Kupferblech ausgeführt.

Ein flächiges Kühlelement 18 steht in einer thermisch leitfähigen Verbindung mit den Kontaktflächen 14 der Halbleiterbauelemente 6. Das flächige Kühlelement 18 ist beispielhaft aus einem metallischen Werkstoff, welcher insbesondere Kupfer und/oder Aluminium enthält, hergestellt, wobei zwischen dem Halbleiterbauelementen 6 und dem flächigen Kühlelement 18 eine Isolationslage 20 aus einem thermisch leitfähigen und elektrisch isolierenden Werkstoff, beispielsweise einen Kunststoff oder einen keramischen Werkstoff, angeordnet ist. Die Isolationslage 20 ist beispielsweise als eine, insbesondere bereits vorhandene, Folie, welche insbesondere aus einem isolierenden Werkstoff hergestellt ist, ausgeführt. Das flächige Kühlelement 18 ist stoffschlüssig mit den Halbleiterbauelementen 6 verbunden. Beispielsweise ist die planare Leiterverbindung 16 auf die Kontaktflächen 14 der Halbleiterbauelemente 6 aufgelötet, während die Isolationslage 20 auf der planaren Leiterverbindung 16 und das flächige Kühlelement 18 auf der Isolationslage 20 durch Adhäsion verbunden stoffschlüssig verbunden ist. Die Isolationslage 20 kann alternativ Teil der planaren Leiterverbindung 16 und/oder des aus einem metallischen Werkstoff hergestellten flächigen Kühlelements 18 sein. Beispielsweise wird eine Isolationslage 20 durch kontrollierte Oxidation des metallischen Werkstoffs hergestellt oder durch ein additives Verfahren, beispielsweise Kaltgasspritzen, aufgebracht. Das flächige Kühlelement 18 kann alternativ aus einem elektrisch isolierenden Werkstoff und einem elektrisch leitfähigen Werkstoff, welcher, insbesondere stoffschlüssig mit dem elektrisch isolierenden Werkstoff verbunden ist, hergestellt sein, wobei der elektrisch isolierende Werkstoff zumindest im Bereich der Kontaktierung zu den Kontaktflächen 14 der Halbleiterbauelemente 6 angeordnet ist, sodass eine dedizierte Isolationslage 20 nicht erforderlich ist.

Das flächige Kühlelement 18, welches beispielsweise eine Dicke von 0,5 mm bis 4 mm, insbesondere 0,5 mm bis 2 mm aufweist, umfasst eine hermetisch verschlossene Kanalstruktur 22, in welcher ein Wärmetransportmedium 24 angeordnet ist, wobei durch die hermetisch verschlossene Kanalstruktur 22 und das Wärmetransportmedium 24 eine pulsierende Heatpipe 26 ausgebildet ist. Das Wärmetransportmedium 24 ist insbesondere als Wärmetransportfluid ausgeführt, welches beispielsweise Wasser, Aceton oder Methanol enthält. Die Kanalstruktur 22 umfasst beispielsweise Kanäle mit einem kreisförmigen Querschnitt, wobei der kreisförmige Querschnitt insbesondere einen maximalen Durchmesser von 3 mm insbesondere 1 mm aufweist. Beispielsweise sind die Kanäle der Kanalstruktur 22 mäanderförmig und/oder schleifenförmig angeordnet, sodass durch die pulsierende Heatpipe 26 eine Wärmespreizung stattfindet. Ferner ist das flächige Kühlelement 18 zumindest abschnittsweise flexibel ausgebildet, wobei eine Form des flächigen Kühlelements 18 an ein Höhenprofil des Schaltungslayouts angepasst ist. Durch eine Anpassung an das Höhenprofil des Schaltungslayouts werden Höhen- und ggf. Winkelversätze aufgrund der Halbleiterbauelemente 6 und weiterer Beschaltung ausgeglichen.

Die zweite Metallisierung 10 des Substrats 4 ist, insbesondere vollflächig und/oder stoffschlüssig, mit einer Wärmesenke 28 verbunden, wobei die Wärmesenke 28 einen Kühlkörper 30 und eine optionale Bodenplatte 32 umfasst. Das flächige Kühlelement 18 ist stoffschlüssig mit der Wärmesenke 28 verbunden und stellt so eine thermische Verbindung der Kontaktflächen 14 der Halbleiterbauelemente 6 mit der Wärmesenke 28 her. In FIG 1 wird das flächige Kühlelement 18 stoffschlüssig mit dem Kühlkörper 30 verbunden. Die stoffschlüssige Verbindung, welche beispielsweise durch Löten hergestellt wird, kann zusätzlich oder alternativ zur optionalen Bodenplatte 32 hergestellt werden. Insbesondere durch die zumindest abschnittsweise flexible Ausführung des flächigen Kühlelements 18 wird eine großflächige Kontaktierung im Bereich der Halbleiterbauelemente 6 und der Wärmesenke 28 ermöglicht, wobei durch die großflächige Kontaktierung gleichmäßigere und niedrigere Temperaturen erreicht werden. Durch das flächige Kühlelement 18 mit der pulsierenden Heatpipe 26 wird ein zweiter Wärmepfad an der Oberseite des Halbleitermoduls 2 geschaffen, der die in den Halbleiterbauelementen 6 entstehende Wärme auf die Wärmesenke 28 ableitet. Dieser zweite Wärmepfad entlastet einen Hauptwärmepfad, welcher über das Substrat 4 verläuft, und übernimmt gleichzeitig die Funktion zusätzlicher Wärmespreizung auf der Wärmesenke 28 sowie innerhalb des Halbleitermoduls 2.

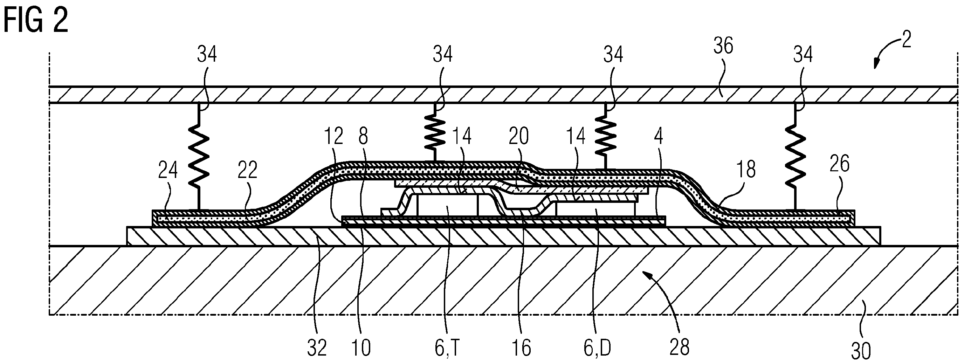

FIG 2 zeigt eine schematische Darstellung einer zweiten Ausgestaltung eines Halbleitermoduls 2 im Querschnitt. Das flächige Kühlelement 18 ist kraftschlüssig mit der Wärmesenke 28 verbunden, wobei die kraftschlüssige Verbindung durch elastische Anpresselemente 34 hergestellt wird. Die elastischen Anpresselemente 34, welche mit einem Gehäuse 36 verbunden sind, sind beispielsweise als Federkontakte, welche insbesondere eine Blattfeder oder eine Spiralfeder umfassen, ausgeführt.

Das flächige Kühlelement 18 kann zumindest teilweise aus einem thermisch leitfähigen und elektrisch isolierenden Werkstoff hergestellt sein. Ein derartiger thermisch leitfähiger und elektrisch isolierender Werkstoff ist beispielsweise ein, insbesondere mit einem keramischen Werkstoff gefüllter, Kunststoff. Die weitere Ausführung des Halbleitermoduls 2 in FIG 2 entspricht der in FIG 1.

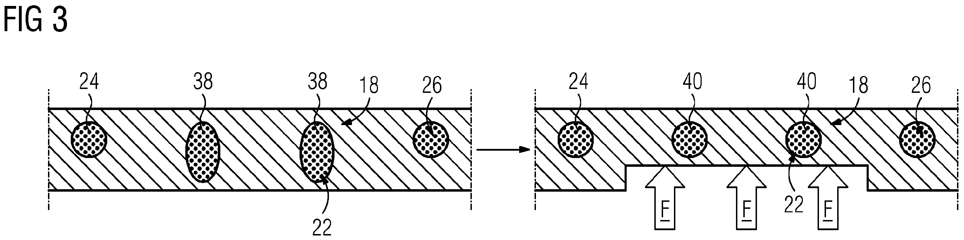

FIG 3 zeigt eine schematische Darstellung einer Deformation eines flächiges Kühlelements 18. Das flächige Kühlelement 18 wird beispielsweise mittels eines additiven Verfahrens, insbesondere durch ein Extrusionsverfahren oder Selektive Lasersintern (SLS), hergestellt. Alternativ wird das flächige Kühlelement 18 mittels eines Gussverfahrens, z.B. Schleuderguss, Gasinjektion, oder durch Verschweißen, Löten oder Kleben von geeignet gebogenen oder geprägten Blechen hergestellt. Hierdurch kann ein räumlich eben erzeugter Grundkörper gebogen, gezogen oder geprägt werden, so dass seine Oberflächen in geeigneter Korrelation zum Höhenprofil des Schaltungslayouts, insbesondere der zu entwärmenden elektronischen Bauteile stehen. Mechanische Spannungen und Spalte werden somit bestmöglich verhindert. Weiterhin ist das flächige Kühlelement 18 zumindest teilweise durch Strangpressen, Kunststoffextrusion oder Spritzguss herstellbar.

Durch eine Deformation bzw. Umformung, mit welcher eine Krafteinwirkung durch eine Kraft F einhergeht, wird eine ursprüngliche Geometrie, insbesondere ein ursprünglicher Querschnitt, zumindest einiger Kanäle, insbesondere im Bereich der Umformung, verändert. Vorgeformte Kanäle 38, welche beispielsweise einen elliptischen Querschnitt aufweisen, gleichen eine Geometrieveränderung durch Deformation zumindest teilweise aus, sodass die endgültig geformten Kanäle 40 einen im Wesentlichen kreisförmigen Zielquerschnitt aufweisen. Die durch Deformation endgültig geformten Kanäle 40 weisen eine Zielgeometrie auf, welche beispielsweise einen im Wesentlichen kreisförmigen Querschnitt zumindest eines endgültig geformten Kanals 40 beinhaltet.

Verbleibende minimale Winkel- und/oder Höhenversätze können durch gezielte Reduktion des Kanal- und/oder Wandungsquerschnitts entschärft werden, da die pulsierende Heatpipe 26 hierdurch flexibler wird. Eine derartige Flexibilisierung ist bei einer pulsierenden Heatpipe 26 aufgrund der geringen Kanalquerschnitte einfach zu realisieren. Eine lokale Querschnittsreduktion durch Einprägungen oder Ausschnitte zwischen den Kanälen ermöglicht weitere Flexibilisierung. Gegebenenfalls verbleibende Geometrieabweichungen zur Schaltung werden in der Montage beispielsweise durch Gap-Filler oder wärmeleitende Klebstoffe ausgeglichen. Die weitere Ausführung des flächigen Kühlelements 18 in FIG 3 entspricht der in FIG 2.

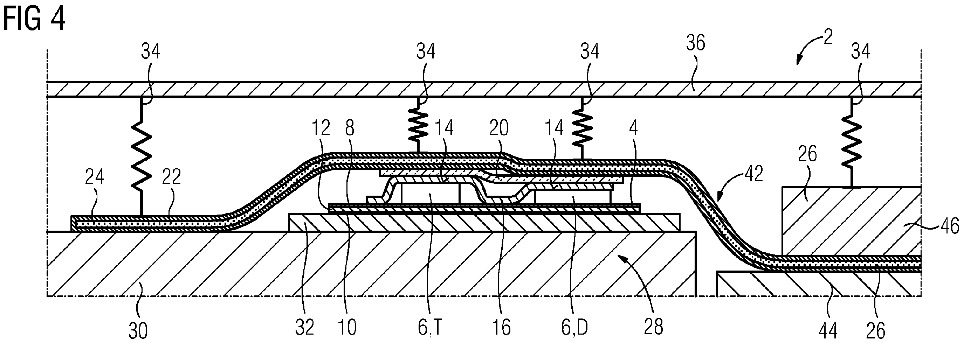

FIG 4 zeigt eine schematische Darstellung einer dritten Ausgestaltung eines Halbleitermoduls 2 im Querschnitt. Das flächige Kühlelement 18 mit der pulsierenden Heatpipe 26 überragt den Kühlkörper 30 mit der Bodenplatte 32, wobei an einem überstehenden Ende 42 weitere Wärmesenken 44, 46 beidseitig zumindest kraftschlüssig kontaktiert sind. Zumindest einer der beiden Wärmesenken 44, 46 kann eine Leiterplatte, insbesondere ein Printed Circuit Board (PCB), umfassen. Die weitere Ausführung des Halbleitermoduls 2 in FIG 4 entspricht der in FIG 2.

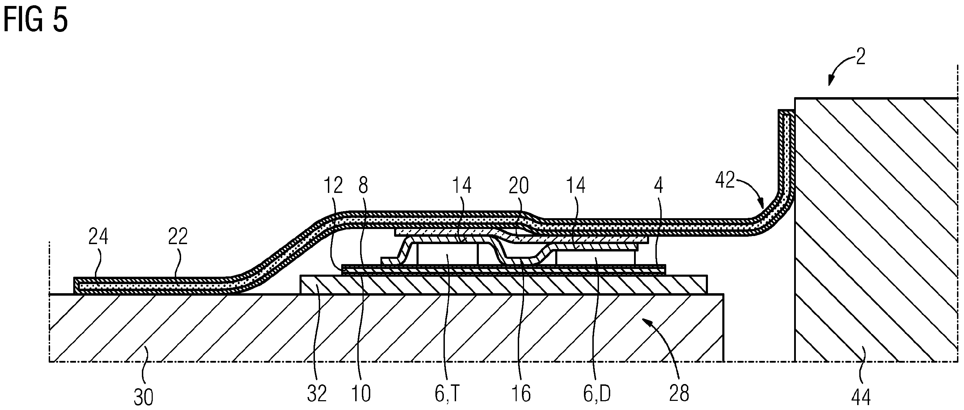

FIG 5 zeigt eine schematische Darstellung einer vierten Ausgestaltung eines Halbleitermoduls 2 im Querschnitt, Das flächige Kühlelement 18 mit der pulsierenden Heatpipe 26 überragt den Kühlkörper 30 mit der Bodenplatte 32, wobei an einem überstehenden Ende 42 eine weitere Wärmesenke 44 kontaktiert ist. Beispielhaft ist das flächige Kühlelement 18 stoffschlüssig mit dem Kühlkörper 30, mit den Halbleiterbauelementen 6 und mit der weiteren Wärmesenke 44 verbunden. Das flächige Kühlelement 18 ist beim Bereich der stoffschlüssigen Verbindung mit der weiteren Wärmesenke 44 senkrecht zur stoffschlüssigen Verbindung mit dem Kühlkörper 30 angeordnet. Die weiteren Wärmesenke 44 kann eine Leiterplatte, insbesondere ein Printed Circuit Board (PCB), umfassen. Die weitere Ausführung des Halbleitermoduls 2 in FIG 5 entspricht der in FIG 4.

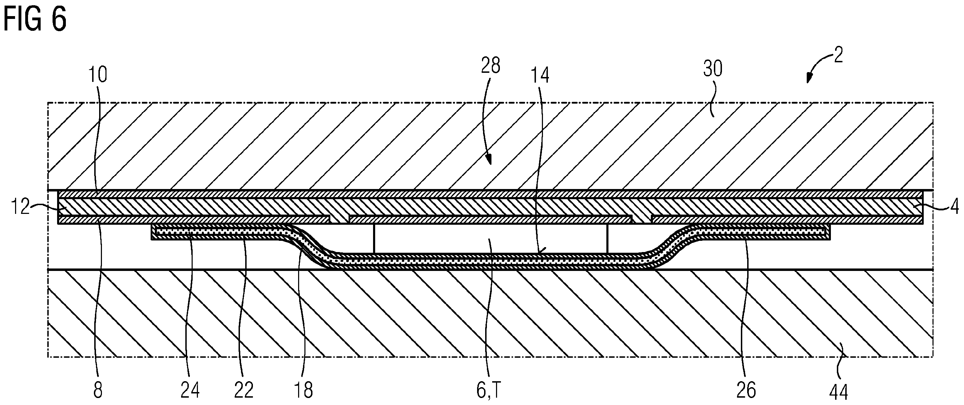

FIG 6 zeigt eine schematische Darstellung einer fünften Ausgestaltung eines Halbleitermoduls 2 im Querschnitt. Das flächige Kühlelement 18 ist mit der Kontaktfläche 14 des als Transistor T ausgeführten Halbleiterbauelements 6 sowie mit der ersten Metallisierung 8 des Substrats 4 kontaktiert, sodass eine thermische Verbindung zwischen der Kontaktfläche 14 des Halbleiterbauelements 6 und der Wärmesenke 28 herstellt wird. Aus Gründen der Übersichtlichkeit ist ein Steuerkontakt des Transistors T auch in FIG 6 nicht dargestellt.

Beispielsweise ist das flächige Kühlelement 18 aus einem metallischen Werkstoff hergestellt und ist als Leiter ausgeführt, welcher unmittelbar mit der Kontaktfläche 14 des Halbleiterbauelements 6 kontaktiert ist. Unter einer unmittelbaren Kontaktierung ist eine direkte Kontaktierung zu verstehen, die Verbindungsmittel zur Herstellung der stoffschlüssigen Verbindung, wie Kleber, Lötzinn oder Sinterpaste, einschließt, ein zusätzliches Verbindungselement, wie einen zusätzlichen Leiter, ein Metallblech oder einen Abstandshalter, jedoch ausschließt. Beispielsweise ist das aus einem metallischen Werkstoff hergestellte flächige Kühlelement 18 stoffschlüssig mit der Kontaktfläche 14 des Halbleiterbauelements 6 sowie mit der ersten Metallisierung 8 des Substrats 4 verbunden. Die stoffschlüssige Verbindung wird beispielsweise durch Löten hergestellt. Zusätzlich zur Wärmetransport leitet das aus einem metallischen Werkstoff hergestellte flächige Kühlelement 18 einen Laststromes des kontaktierten Halbleiterbauelements 6, das flächige Kühlelement 18 fungiert also als Leiter.

Optional ist eine weitere Wärmesenke 44, welche beispielhaft parallel zum Substrat 4 verlaufend angeordnet ist, mit dem flächigen Kühlelement 18 kontaktiert. Insbesondere erfolgt die Kontaktierung zur weiteren Wärmesenke 44 elektrisch isolierend und thermisch leitend, sodass eine Entwärmung über die weitere Wärmesenke 44 stattfinden kann, jedoch kein Strom abfließt. Die weiteren Wärmesenke 44 kann eine Leiterplatte, insbesondere ein Printed Circuit Board (PCB), umfassen. Ferner kann die weitere Wärmesenke 44 das flächige Kühlelement 18, insbesondere zusätzlich, auf die Kontaktfläche 14 des Halbleiterbauelements 6 pressen. Zur elektrischen Isolierung weist die weitere Wärmesenke 44 beispielsweise eine Beschichtung mit einem thermisch leitfähigen Isolator, insbesondere einem keramischen Werkstoff, zumindest im Bereich der Kontaktierung mit dem flächige Kühlelement 18 auf. Alternativ ist zwischen dem flächigen Kühlelement 18 und der weiteren Wärmesenke 44, wie in FIG 1 gezeigt, eine Isolationslage 20 angeordnet. Für eine gezielte Isolation kann auf das flächige Kühlelement 18 eine Kunststofffolie auflaminiert werden. Das flächige Kühlelement 18 kann alternativ aus einem Verbundwerkstoff hergestellt sein, der einen isolierenden Werkstoff zumindest im Bereich der Kontaktierung zu der weiteren Wärmesenke 44 aufweist, sodass eine dedizierte Isolationslage 20 nicht erforderlich ist. Insbesondere kann das flächige Kühlelement 18 als IMS-Substrat bzw. als 3D-MID ausgeführt sein. Die weitere Ausführung des Halbleitermoduls 2 in FIG 6 entspricht der in FIG 1.

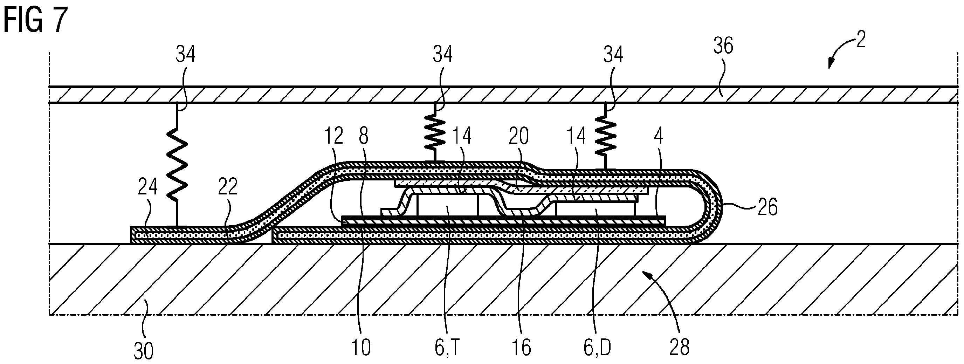

FIG 7 zeigt eine schematische Darstellung einer sechsten Ausgestaltung eines Halbleitermoduls 2 im Querschnitt. Das flächige Kühlelement 18 ist gefaltet ausgeführt und zusätzlich zwischen dem Substrat 4 und der Wärmesenke 28 verlaufend angeordnet, sodass eine beidseitige Entwärmung der Halbleiterbauelemente 6 durch die pulsierende Heatpipe 26 erfolgt, wodurch eine homogene Temperaturverteilung erreicht wird. Die weitere Ausführung des Halbleitermoduls 2 in FIG 7 entspricht der in FIG 2.

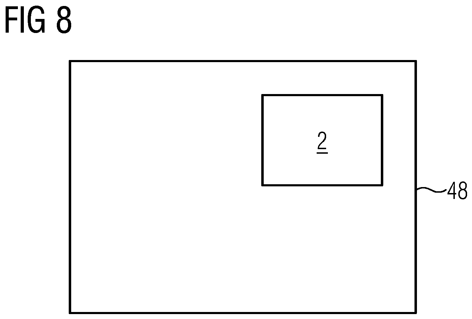

FIG 8 zeigt eine schematische Darstellung eines Stromrichters 48 mit einem Halbleitermodul 2. Der Stromrichter 48 kann mehr als ein Halbleitermodul 2 umfassen.

Zusammenfassend betrifft die Erfindung ein Halbleitermodul 2 mit einem Substrat 4 und zumindest einem auf dem Substrat 4 kontaktierten Halbleiterbauelement 6, wobei das Substrat 4, insbesondere stoffschlüssig, mit einer Wärmesenke 28 verbunden ist. Um, im Vergleich zum Stand der Technik, eine effektivere Entwärmung zu ermöglichen, wird ein flächiges Kühlelement 18 vorgeschlagen, welches eine hermetisch verschlossene Kanalstruktur 22 aufweist, in welcher ein Wärmetransportmedium 24 angeordnet ist, wobei durch die hermetisch verschlossene Kanalstruktur 22 und das Wärmetransportmedium 24 eine pulsierende Heatpipe 26 ausgebildet ist, wobei über das flächige Kühlelement 18 eine thermische Verbindung zwischen einer dem Substrat 4 abgewandten Seite des zumindest einen Halbleiterbauelements 6 und der Wärmesenke 28 herstellt ist.

## Patentansprüche

1. Halbleitermodul (2) mit einem Substrat (4) und zumindest einem auf dem Substrat (4) kontaktierten Halbleiterbauelement (6),
wobei das Substrat (4), insbesondere stoffschlüssig mit einer Wärmesenke (28), verbunden ist,
**gekennzeichnet durch** ein flächiges Kühlelement (18),
welches eine hermetisch verschlossene Kanalstruktur (22) aufweist, in welcher ein Wärmetransportmedium (24) angeordnet ist,
wobei durch die hermetisch verschlossene Kanalstruktur (22) und das Wärmetransportmedium (24) eine pulsierende Heatpipe (26) ausgebildet ist,
wobei über das flächige Kühlelement (18) eine thermische Verbindung zwischen einer dem Substrat (4) abgewandten Seite des zumindest einen Halbleiterbauelements (6) und der Wärmesenke (28) herstellt ist.

2. Halbleitermodul (2) nach Anspruch 1,
wobei das flächige Kühlelement (18) zumindest abschnittsweise flexibel ausgebildet ist.

3. Halbleitermodul (2) nach einem der Ansprüche 1 oder 2, wobei eine Form des flächigen Kühlelements (18) an ein Höhenprofil des jeweiligen Schaltungslayouts angepasst ist.

4. Halbleitermodul (2) nach einem der vorherigen Ansprüche, wobei das flächige Kühlelement (18) stoffschlüssig oder kraftschlüssig mit dem Halbleiterbauelement (6) verbunden ist.

5. Halbleitermodul (2) nach einem der vorherigen Ansprüche, wobei das flächige Kühlelement (18) zumindest teilweise mittels eines additiven Verfahrens hergestellt ist.

6. Halbleitermodul (2) nach einem der Ansprüche 1 bis 4, wobei das flächige Kühlelement (18) mittels eines Gussverfahrens hergestellt ist.

7. Halbleitermodul (2) nach einem der Ansprüche 1 bis 4, wobei das flächige Kühlelement (18) aus profilierten und gefügten Blechen hergestellt ist.

8. Halbleitermodul (2) nach einem der vorherigen Ansprüche, wobei die hermetisch verschlossene Kanalstruktur (22) einen endgültig geformten Kanal (40) aufweist,
welcher durch Deformation des flächigen Kühlelements (18) aus einem vorgeformten Kanal (38) hergestellt ist,
wobei sich eine Geometrie des endgültig geformten Kanals (40) von einer Geometrie des vorgeformten Kanals (38) unterscheidet.

9. Halbleitermodul (2) nach einem der vorherigen Ansprüche, wobei das flächige Kühlelement (18) zumindest teilweise aus einem thermisch leitfähigen und elektrisch isolierenden Werkstoff hergestellt ist.

10. Halbleitermodul (2) nach einem der Ansprüche 1 bis 8, wobei das flächige Kühlelement (18) aus einem metallischen Werkstoff hergestellt ist und
wobei zwischen dem Halbleiterbauelement (6) und dem flächigen Kühlelement (18) eine Isolationslage (20) angeordnet ist.

11. Halbleitermodul (2) nach einem der Ansprüche 1 bis 8, wobei das flächige Kühlelement (18) zumindest teilweise aus einem metallischen Werkstoff hergestellt ist und
wobei das flächige Kühlelement (18) unmittelbar mit einer Kontaktfläche (14) des Halbleiterbauelements (6) kontaktiert ist.

12. Halbleitermodul (2) nach Anspruch 11,
wobei das flächige Kühlelement (18) zum Leiten eines Laststromes des kontaktierten Halbleiterbauelements (6) konfiguriert ist.

13. Stromrichter (48) mit mindestens einem Halbleitermodul (2) nach einem der vorherigen Ansprüche.

14. Verfahren zur Herstellung eines Halbleitermoduls (2) mit einem Substrat (4) und zumindest einem auf dem Substrat (4) kontaktierten Halbleiterbauelement (6),
wobei das Substrat (4), insbesondere stoffschlüssig, mit einer Wärmesenke (28) verbunden wird,
**dadurch gekennzeichnet, dass** über ein flächiges Kühlelement (18) eine thermische Verbindung zwischen einer dem Substrat (4) abgewandten Seite des zumindest einen Halbleiterbauelements (6) und der Wärmesenke (28) herstellt wird, wobei das flächige Kühlelement (18) eine hermetisch verschlossene Kanalstruktur (22) aufweist, in welcher ein Wärmetransportmedium (24) angeordnet wird,
wobei durch die hermetisch verschlossene Kanalstruktur (22) und das Wärmetransportmedium (24) eine pulsierende Heatpipe (26) ausgebildet wird.

15. Verfahren nach Anspruch 14,
wobei das flächige Kühlelement (18) zumindest abschnittsweise flexibel ausgebildet wird,
wobei eine Form des flächigen Kühlelements (18) an ein Höhenprofil des jeweiligen Schaltungslayouts angepasst wird.

16. Verfahren nach einem der Ansprüche 14 oder 15,
wobei das flächige Kühlelement (18) stoffschlüssig oder kraftschlüssig mit dem Halbleiterbauelement (6) verbunden wird.

17. Verfahren nach einem der Ansprüche 14 bis 16,
wobei durch Deformation des flächigen Kühlelements (18) aus einem vorgeformten Kanal (38) ein endgültig geformter Kanal (40) der hermetisch verschlossenen Kanalstruktur (22) hergestellt wird,
wobei sich eine Geometrie des endgültig geformten Kanals (40) von einer Geometrie des vorgeformten Kanals (38) unterscheidet.
